# FASCICULE DE BREVET EUROPEEN

(11) **EP 3 352 959 B1**
(45) Date de publication et mention de la délivrance du brevet: **18.08.2021**
(21) Numéro de dépôt: 16785220.1
(22) Date de dépôt: 23.09.2016
(51) Int. Cl.: B28B 19/00, B28B 23/00, H02S 20/26, H01L 31/02

(54) **PROCEDE DE FABRICATION D'UN ELEMENT DE CONSTRUCTION PREFABRIQUE ET PHOTOVOLTAÏQUE**
VERFAHREN ZUR HERSTELLUNG EINES VORGEFERTIGTEN FOTOVOLTAISCHEN BAUELEMENTS
METHOD FOR MANUFACTURING A PRE-FABRICATED PHOTOVOLTAIC CONSTRUCTION ELEMENT

(30) Priorité: 25.09.2015 FR 1559076
(43) Date de publication de la demande: 01.08.2018
(73) Titulaire: Holcim Technology Ltd, 6300 Zug (CH)
(72) Inventeur: HORGNIES, Matthieu, 38291 Saint Quentin Fallavier (FR); DUBOIS-BRUGGER, Isabelle, 38291 Saint Quentin Fallavier (FR); LEGRAND, Fabienne, 38291 Saint Quentin Fallavier (FR); MOLINES, Gérard, 38291 Saint Quentin Fallavier (FR)
(74) Mandataire: Regimbeau
(86) Numéro de dépôt international: PCT/FR2016/052425
(87) Numéro de publication internationale: WO 2017/051137

(56) Documents cités:
- WO-A1-97/15953
- DE-A1- 3 247 468
- DE-A1- 4 141 414
- FR-A1- 2 734 753
- JP-A- 2002 368 249
- US-A1- 2012 110 932
- US-A1- 2014 144 491

## Description

### CONTEXTE DE L'INVENTION

La présente invention concerne le domaine technique de la production d'électricité à partir d'énergies renouvelables, en particulier l'énergie solaire, grâce à l'effet photovoltaïque.

Plus précisément, la présente invention se rapporte à un procédé de fabrication d'un élément préfabriqué destiné à la construction et comportant au moins un module photovoltaïque destiné à produire de l'électricité.

La crise énergétique et les considérations environnementales poussent les industriels à trouver des solutions économes en énergie et respectueuses de l'environnement. Les solutions photovoltaïques peuvent participer à cet effort en apportant des solutions innovantes dans de nombreux domaines, notamment le domaine technique du béton.

En effet, les villes comprennent de nombreux bâtiments, immeubles, ouvrages d'art ou infrastructures (notamment de transport) réalisés en béton et offrant de grandes capacités de surface qu'il serait pertinent d'utiliser pour produire de l'électricité à partir de l'énergie solaire.

Il est connu d'installer des panneaux photovoltaïques sur des surfaces en béton ultérieurement à la construction de ces surfaces.

Cependant, de telles installations nécessitent au préalable l'installation d'une structure porteuse qui parfois nécessite certaines adaptations pour se conformer à la surface en béton sur laquelle les panneaux photovoltaïques sont destinés à être installés.

Par ailleurs, une telle installation nécessite d'avoir recours à une main d'oeuvre spécialisée.

Ainsi, il apparait intéressant d'utiliser les surfaces en bétons disponibles dans les villes et cela dès le moment de leur construction de manière à limiter le recours ultérieur à des ressources supplémentaires.

La demande de brevet FR14/55388 décrit un procédé de fabrication d'un élément préfabriqué en béton destiné à la réalisation de bâtiments, immeubles, ouvrage d'art ou infrastructures et capable de produire de l'électricité.

Cet élément préfabriqué comprend une couche mince photovoltaïque déposée sur une de ces surfaces, ce qui ne nécessite pas d'avoir recours à une structure porteuse pour fabriquer un panneau photovoltaïque à partir d'une pluralité de ces éléments.

Un tel procédé consiste à revêtir la surface d'un béton durci d'un film polymère obtenu par polymérisation sous l'action de radiations, puis à déposer une couche mince photovoltaïque sur ce film polymère à l'aide de techniques dont le principe de base consiste à déposer ou à condenser le matériau recouvrant formant la couche mince sous vide partiel, par exemple, en utilisant une pression de 10-2 à 10-4 Torr (de 1,36 à 1,39 kPa), alors que le matériau support est chauffé à une température constante.

Ce procédé est satisfaisant en ce qui concerne l'adhérence de la couche mince photovoltaïque sur la surface de l'élément en béton.

Néanmoins, un tel procédé nécessite la mise en œuvre de techniques complexes qu'il est difficile de maitriser au cours d'une production de masse à l'échelle industrielle.

### PRESENTATION DE L'INVENTION

La présente invention vise à résoudre tout ou partie des problèmes exposés ci-dessus.

Aussi, le problème technique que se propose de résoudre la présente invention consiste à simplifier le procédé de fabrication d'un élément préfabriqué destiné à la construction et comportant un module photovoltaïque destiné à produire de l'électricité.

Dans ce but, la présente invention se rapporte à un procédé de fabrication d'un élément préfabriqué destiné à la construction et à la production d'électricité suivant la revendication 1.

Un élément préfabriqué destiné à la construction peut être tout élément ou partie d'un élément d'une construction comme par exemple une fondation, un soubassement, un mur, une poutre, un pilier, une pile de pont, un parpaing, un bloc, un poteau, un escalier, un panneau, notamment un panneau de façade, une corniche, une tuile ou un toit terrasse.

Néanmoins un tel élément préfabriqué est également destiné à la production d'électricité et doit donc pouvoir être exposé à une source lumineuse, notamment au soleil.

De manière inattendue, les inventeurs ont mis en évidence qu'il est possible de faire adhérer de manière convenable un module photovoltaïque sur du béton frais en utilisant un matériau adhésif structurel qui contrairement à un préjugé, ne perd pas son adhérence du fait de son utilisation avec du béton frais.

Ce procédé permet de simplifier considérablement la fabrication d'éléments préfabriqués en béton comprenant un module photovoltaïque.

En effet, le placement et le collage du module photovoltaïque directement au contact du moule de coffrage permet un gain de temps très appréciable, typiquement inférieur à un jour par rapport à des étapes de collage ou de laminage d'un module photovoltaïque sur béton déjà durci nécessitant classiquement plusieurs jours.

De plus, ce procédé s'abstient de tout problème de dégazage d'eau et permet de mouler plus aisément la forme et les dimensions de panneaux en béton, tout en prévoyant facilement l'espace nécessaire à la sortie des connecteurs électriques.

Selon une mise en oeuvre du procédé ne faisant pas partie de l'invention, l'au moins un module photovoltaïque est positionné à l'horizontal contre une des parois du moule de coffrage, en particulier la paroi de fond du moule de coffrage.

Cette disposition permet de reporter sur l'une des parois du moule de coffrage plus résistante tout ou partie de la force qu'exerce le béton frais sur l'au moins un module photovoltaïque, ce qui préserve le module photovoltaïque.

Selon une mise en oeuvre du procédé, l'au moins un module photovoltaïque est positionné à la vertical contre une des parois du moule de coffrage, en particulier une paroi latérale du moule de coffrage.

Cette disposition permet d'envisager un élément préfabriqué comprenant plusieurs modules photovoltaïques disposés sur des côtés différents de l'élément.

Selon une mise en oeuvre du procédé, le procédé comprend en outre une étape préalable de sablage de la face arrière de l'au moins un module photovoltaïque.

Cette disposition permet d'augmenter la surface spécifique de la face arrière de l'au moins un module photovoltaïque et donc d'augmenter l'adhésion du matériau adhésif structurel.

Selon une mise en oeuvre du procédé, le matériau adhésif structurel est appliqué par pulvérisation, à l'aide d'un rouleau ou à l'aide d'un pinceau.

Cette disposition permet de simplifier l'application du matériau adhésif structurel.

Selon une mise en oeuvre du procédé, le matériau adhésif structurel comprend au moins un polymère, par exemple de la famille des époxydes, des polyuréthanes, des acryliques ou des styrène-acryliques.

Selon une mise en oeuvre du procédé, le procédé comprend en outre une étape de séchage ou de réticulation du polymère avant l'étape consistant à couler du béton frais.

Cette étape peut par exemple mise en oeuvre lorsque le matériau adhésif structurel est un polymère de la famille des styrène-acryliques.

Selon une mise en oeuvre du procédé, le béton a un rapport eau sur ciment (E/C) d'au plus 1, de préférence de 0,20 à 0,27.

Selon une mise en oeuvre du procédé, le béton est un béton haute performance, un béton ultra-haute performance, un béton autoplaçant ou un béton moussé.

Ce type de béton adhère particulièrement bien au matériau adhésif structurel.

Selon une mise en oeuvre du procédé, le procédé comprend en outre une étape ultérieure de démoulage, de préférence 18 heures après l'étape de coulage du béton frais.

Selon une mise en oeuvre du procédé, le procédé comprend en outre une étape ultérieure de traitement thermique après l'étape de démoulage.

Cette disposition permet d'améliorer la cohésion entre les différents matériaux utilisés pour réaliser l'élément préfabriqué.

Il est également décrit un élément préfabriqué susceptible d'être obtenu par un procédé tel que décrit précédemment dans lequel au moins une partie des connectiques de l'au moins un module photovoltaïque sont prises dans le béton.

### PRESENTATION DES FIGURES

De toute façon, l'invention sera bien comprise à l'aide de la description qui suit, en référence aux dessins schématiques annexés représentant, à titre d'exemple non limitatif, les différentes étapes d'un procédé de fabrication d'un élément préfabriqué.
La figure 1 illustre l'agencement entre le moule de coffrage et le module photovoltaïque selon une première mise en oeuvre du procédé ne faisant pas partie de l'invention.
La figure 2 est une vue de profil d'un élément préfabriqué obtenu à partir de la première mise en oeuvre du procédé illustré à la figure 1.
La figure 3 illustre l'agencement entre le moule de coffrage et le module photovoltaïque selon une deuxième mise en oeuvre du procédé selon l'invention.
La figure 4 est une vue de profil d'un élément préfabriqué obtenu à partir de la deuxième mise en oeuvre du procédé selon l'invention illustré à la figure 3.

### DESCRIPTION DETAILLEE

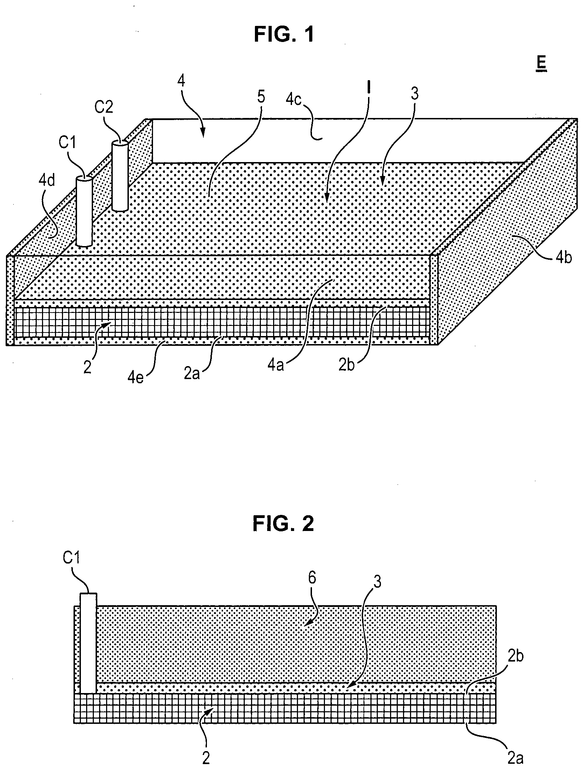

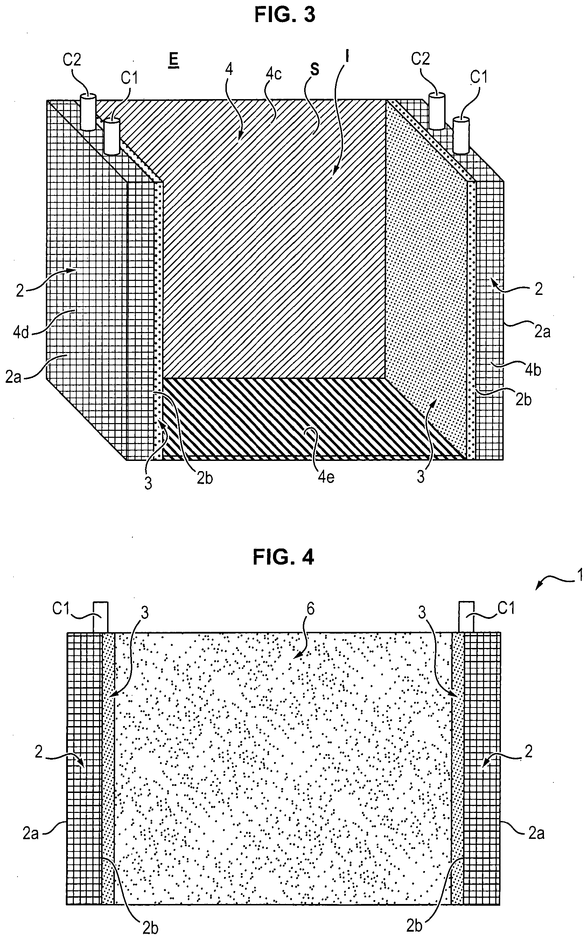

Comme illustré aux figures 1 et 3, la mise en oeuvre d'un procédé de fabrication d'un élément préfabriqué 1 destiné à la construction et à la production d'électricité selon l'invention consiste tout d'abord à disposer d'au moins un module photovoltaïque 2 destiné à produire de l'électricité.

Dans l'exemple des figures 1 et 2, l'élément préfabriqué 1 comprend un seul module photovoltaïque 2 tandis que dans l'exemple présenté aux figures 3 et 4 l'élément préfabriqué comprend deux modules photovoltaïques 2.

Bien entendu, la présente invention pourrait comprendre un nombre différent de modules photovoltaïques 2, ce nombre étant déterminé selon les applications envisagées pour l'élément préfabriqué 1.

Un module photovoltaïque 2 comprend généralement une pluralité de cellules photovoltaïques reliées électriquement entre elles en série.

Les cellules photovoltaïques peuvent être à base de composés minéraux, de composés métalliques, de composés organiques ou de composés hybrides organique-minéral appelées aussi cellules photovoltaïques hydrides.

Les composés minéraux ou métalliques convenant pour réaliser les cellules photovoltaïques peuvent être à base de silicium amorphe, de silicium cristallin, de silicium polycristallin, de silicium liquide, de tellure de cadmium, de cuivre-indium-sélénium, de cuivre-indium-gallium-sélénium, de cuivre-indium-gallium-disélénide-disulphide, d'arséniure de gallium, de cuivre-zinc-étain-sélénium, de cuivre-zinc-étain-disélénide-disulphide, d'oxyde d'indium-étain, de cuivre, de molybdène, de chalcopyrite ou leurs mélanges.

Les composés organiques convenant pour réaliser les cellules photovoltaïques peuvent être à base de deux composés, l'un donneur d'électrons et l'autre accepteur d'électrons. Parmi les donneurs d'électrons, on peut citer les polyarylènes, les poly(arylène-vinylène)s, les poly(arylènes-éthynylène)s ou leurs mélanges.

A titre d'exemple, on peut citer du poly 3-hexyl thiophène (dit aussi P3HT)) ou du poly[2-méthoxy-5-(3,7-diméthyloctyloxy)-1,4-phénylène-vinylène] (dit aussi MDMO-PPV).

Parmi les accepteurs d'électrons on peut citer les composés à base de fullerène tel que le [6,6]-phényl-C61-butanoate de méthyle (dit aussi PCBM).

Il peut aussi être envisagé que les cellules photovoltaïques peuvent être composées de pigments photosensibles ; on parle alors de cellule à colorants ou de cellule de Graëtzel (dit aussi DSSC ou DSC). Parmi les pigments photosensibles composant les cellules photovoltaïques à colorants ou de Graëtzel, on pourra citer le dioxyde de titane.

L'ensemble des cellules photovoltaïques formant un module photovoltaïque 2 sont recouvertes d'un polymère transparent résistant aux agressions extérieures (eau, air, UV...).

Ce polymère servira de support de prédilection pour un matériau adhésif structurel décrit plus loin dans le texte.

Le module photovoltaïque 2 présente la forme d'un panneau rectangulaire avec une face avant 2a et une face arrière 2b.

La face avant 2a est destinée à être orientée vers une source lumineuse de manière à permettre aux cellules photovoltaïques d'engendrer l'effet photovoltaïque.

La face arrière 2b est quant à elle opposée à la face avant 2a.

En outre, le module photovoltaïque 2 comprend deux connecteurs électriques C1, C2 faisant saillie de la face arrière 2b.

Ces connecteurs électriques C1, C2 sont utilisés pour récupérer l'électricité produite par le module photovoltaïque 2.

La deuxième étape du procédé de fabrication selon l'invention consiste à disposer d'un moule de coffrage 4.

Dans l'exemple proposé, le moule de coffrage 4 présente la forme générale d'un parallélépipède comprenant plusieurs parois, dont quatre parois latérales 4a, 4b, 4c, 4d positionnées verticalement et une paroi de fond 4e positionnée horizontalement.

Ces parois 4a, 4b, 4c, 4d, 4e définissent deux zones de l'espace, une première zone de l'espace située à l'intérieur du moule de coffrage 4, dite zone intérieure I du moule de coffrage 4, et une deuxième zone de l'espace située à l'extérieur du moule de coffrage 4, dite zone extérieure E au moule de coffrage 4.

En outre, le moule de coffrage comprend également une ouverture 5 disposée en regard du fond 4e, et utilisée lors d'une étape ultérieure pour l'introduction de béton frais 6 dans le moule du coffrage 4.

Le moule de coffrage 4 utilisé peut être réalisé à partir de plusieurs matériaux, tels que le bois bakélisé, le polychlorure de vinyle (PVC), le polydiméthylsiloxane (PDMS) ou encore l'acier.

Après cette étape, plusieurs variantes sont envisageables pour introduire le moule photovoltaïque 2 dans le moule de coffrage 4.

Une première de ces variantes consiste à positionner l'au moins un module photovoltaïque 2 contre une des parois 4a, 4b, 4c, 4d, 4e du moule de coffrage 4, la face avant 2a du module photovoltaïque 2 étant disposé en regard de ladite paroi 4a, 4b, 4c, 4d, 4e.

De manière préférée, le module photovoltaïque 2 est dimensionné de manière à ce que sa face avant 2a recouvre entièrement la face intérieure de la paroi 4a, 4b, 4c, 4d, 4e contre laquelle il est positionné.

Dans l'exemple illustré aux figures 1 et 2 et ne faisant pas partie de l'invention, le module photovoltaïque 2 a été positionné contre la paroi de fond 2e.

Une deuxième de ces variantes consiste à remplacer une des parois 4a, 4b, 4c, 4d, 4e du moule de coffrage par tout ou partie de l'au moins un module photovoltaïque 2, la face avant 2a du module photovoltaïque 2 étant disposée en regard d'une zone située à l'extérieur du moule de coffrage 4.

Dans l'exemple illustré aux figures 3 et 4, l'élément préfabriqué 1 comprend deux modules photovoltaïques 2, tous deux disposés verticalement et remplaçant deux parois latérales 4a, 4b, 4c, 4d opposées.

Ainsi, les deux modules photovoltaïques 2 sont utilisés comme des coffrages perdus.

Dans cette variante, des portions d'extrémité de la face arrière 2b peuvent être positionnés en regard du flanc d'autres parois adjacentes du moule de coffrage 4.

L'apposition d'un joint étanche entre ces portions d'extrémité de la face arrière 2b du module photovoltaïque 2 et une paroi 4a, 4b, 4c, 4d, 4e du moule de coffrage 4 ou des portions d'extrémité de la face arrière 2b d'un autre module photovoltaïque 2, potentiellement renforcé par un cadre métallique disposé autour du moule de coffrage 4 et agissant comme un serre-joint, pourra être utilisé pour assurer la cohésion entre les différentes parois 4a, 4b, 4c, 4d, 4e du moule de coffrage 4.

Une combinaison de ces deux variantes peut également être envisagée, par exemple en positionnant la face avant d'un module photovoltaïque 2 contre une paroi 4a, 4b, 4c, 4d, 4e du moule de coffrage 4, et en remplaçant une autre de ces parois 4a, 4b, 4c, 4d, 4e par un module photovoltaïque 2 dont la face avant serait orientée en regard de la zone extérieure E au moule de coffrage 4.

Le procédé selon l'invention comprend également une étape consistant à déposer un matériau adhésif structurel 3 sur tout ou partie de la face arrière 2b de l'au moins un module photovoltaïque 2 disposée en regard de la zone intérieure I du moule de coffrage 4.

Ce matériau adhésif structurel 3 peut être appliqué sur la face arrière 2b du module photovoltaïque 2 par pulvérisation, à l'aide d'un rouleau ou à l'aide d'un pinceau.

Cette étape peut être réalisée avant ou après l'introduction du panneau photovoltaïque 2 dans le moule de coffrage 4.

Le matériau adhésif structurel 3 est de préférence un polymère, par exemple une colle epoxyde ou bien une colle acrylique.

Selon une variante de l'invention, le procédé peut comprendre une étape préalable de sablage de la face arrière 2b du module photovoltaïque 2.

Cette étape de sablage permet d'augmenter la surface spécifique de la face arrière 2b du module photovoltaïque 2, ce qui favorise l'adhérence du polymère.

Cette étape peut le cas échéant être suivie d'un nettoyage au chiffon imbibé de solvant pour enlever les poussières et faciliter l'application du polymère.

Le procédé comprend ensuite une étape consistant à couler un béton frais 6 dans le moule de coffrage 4 de manière à recouvrir le matériau adhésif structurel 3.

Le béton frais 6 est introduit dans le moule de coffrage 4 par l'ouverture 5 jusqu'à ce que la forme définitive de l'élément préfabriqué 1 soit atteinte.

Le béton frais est de préférence un béton haute performance ou un béton ultra-haute performance.

Cependant, des essais ont montré que d'autres formulations de bétons permettaient également de fabriquer un élément préfabriqué 1 comprenant un module photovoltaïque 2, notamment un béton auto-plaçant ou du béton moussé.

Dans le cas d'une utilisation de matériau adhésif structurel 3 du type colle epoxyde, alors le béton est introduit alors même que la colle epoxyde est encore fluide, typiquement au bout de 15 minutes après l'application de la colle.

Le collage est fait à température ambiante et l'apport de chaleur réalisé par la réaction d'hydratation du béton accélère le collage.

Dans le cas d'une utilisation de matériau adhésif structurel 3 du type colle acrylique, alors le béton n'est introduit qu'une fois que la colle est sèche et a réticulé, typiquement après 15 à 30 minutes selon la température ambiante, sachant que plus la température ambiante est élevée et plus le temps de réticulation est faible.

Une fois que la colle est réticulée, le béton frais 6 peut être déversé dans le moule de coffrage 4 jusqu'à une période pouvant atteindre 48 heures.

Le procédé selon l'invention pourrait éventuellement être utilisé pour la fabrication d'éléments préfabriqués 1 dits minces, par exemple ceux ayant un rapport entre la longueur et l'épaisseur supérieur à environ 10, ayant généralement une épaisseur de 10 à 30 mm, par exemple des éléments de revêtement de façade.

De tels éléments de revêtement de façade sont de préférence fabriqués selon la mise en œuvre du procédé illustré aux figures 1 et 2 ne faisant pas partie de l'invention dans laquelle le module photovoltaïque 2 est placé horizontalement contre la paroi de fond 2e du moule de coffrage 4.

Des éléments préfabriqués 1 plus structurels sont quant à eux de préférence fabriqués selon la mise en oeuvre du procédé illustré aux figures 3 et 4 dans laquelle le module photovoltaïque 2 est placé verticalement contre une paroi latérale 2a, 2b, 2c, 2d du moule de coffrage 4.

Bien que l'invention ait été décrite en liaison avec des exemples particuliers de réalisation, il est bien évident qu'elle n'y est nullement limitée et qu'elle comprend tous les équivalents techniques des moyens décrits ainsi que leurs combinaisons tout en restant dans l'étendue de la protection comme définie par les revendications. combinaisons.

Des exemples, illustrant l'invention sans en limiter la portée de protection, vont être décrits ci-après.

### EXEMPLES

Dans les différents exemples suivants, les pourcentages sont exprimés en pourcentages massiques.

Les exemples qui suivent montrent comment fabriquer un élément préfabriqué en béton destiné à la construction et à la production d'électricité directement après démoulage.

Les composants suivants, utilisés pour fabriquer deux formulations distinctes de béton, sont disponibles auprès des fournisseurs suivants :
(1) Ciment Portland blanc : Lafarge-France Le Teil
(2) Ciment Portland gris : Lafarge-France Val d'Azergues
(3) Filler calcaire DURCAL 1 : OMYA
(4) Filler calcaire BETOCARB HP Orgon : OMYA
(5) Calcaire précipité SOCAL31 : SOLVAY
(6) Fumées de silice MST : SEPR (Société Européenne des Produits Réfractaires)
(7) Sable BE01 : Sibelco France (Carrière de SIFRACO BEDOIN)
(8) Sable 0/4 mm : Lafarge France (St Bonnet La Petite Craz)
(9) Graviers 5/10 mm : Lafarge France (St Bonnet La Petite Craz)
(10) Adjuvant Ductal F2 : Chryso
(11)Adjuvant Optima 203 : Chryso
(12) Adjuvant EPB 530-027 : Chryso
(13) Mapeair LA/L : Mapeï

Les ciments Portland utilisés sont du type CEM I 52,5 selon la norme EN 197-1 de février 2001. La fumée de silice possède une taille médiane des particules d'environ 1 micromètre.

Les modules photovoltaïques et les matériaux adhésifs structurels du type polymère, utilisés pour exemplifier l'invention, sont disponibles auprès des fournisseurs suivants :
(1) Modules photovoltaïques en polymères organiques (OPV) : Disasolar
(2) Modules photovoltaïques en silicium polycristallin Solarmodul 4V/250mA : Conrad
(3) Modules photovoltaïques en silicium polycristallin Solarmodul 6V/450mA : Conrad
(4) Modules photovoltaïques souples et semi-transparentes en silicium polycristallin Solarmodul 6V/400mA : Conrad
(5) Modules photovoltaïques souples PVL-68 en silicium amorphe 12V/4,1A : Solariflex
(6) Polymère à base styrène-butadiène INDIL : INDILATEX
(6) Polymère à base styrène-acrylique Acronal S790 : BASF
(7) Polymère à base époxy Resipoly Chrysor C6123 : Chryso

### Formulation (1) de béton à ultra haute performance :

La formulation (1) de béton à ultra haute performance utilisée pour réaliser les essais est décrite dans le tableau (1) suivant :

**Tableau (1) : formulation (1) de béton**

| Composants | Proportion (% en masse par rapport à la masse de la composition) |
|---|---|
| Ciment Portland Blanc Lafarge Le Teil | 31,0 |
| Filler calcaire DURCAL 1 | 9,3 |
| Fumées de silice MST | 6,8 |
| Sable BE01 | 44,4 |
| Eau de gâchée | 7,1 |
| Adjuvant Ductal F2 | 1,4 |

Le rapport eau/ciment est de 0,26. Il s'agit d'un béton ayant une résistance à la compression à 28 jours supérieure à 100 MPa.

Le béton à ultra haute performance selon la formulation (1) a été réalisé au moyen d'un malaxeur de type RAYNERI. L'ensemble de l'opération a été réalisé à 20°C. La méthode de préparation comprend les étapes suivantes :
- A T = 0 seconde : mettre le ciment, le filler calcaire, les fumées de silice et le sable dans le bol malaxeur et malaxer durant 7 minutes (15 tours/min) ;
- A T = 7 minutes : ajouter l'eau et la moitié de la masse d'adjuvant et malaxer pendant 1 minute (15 tours/min) ;
- A T = 8 minutes : ajouter le restant d'adjuvant et malaxer pendant 1 minute (15 tours/min) ;
- A T = 9 minutes : malaxer pendant 8 minutes (50 tours/min) ;
- A T = 17 minutes : malaxer pendant 1 minute (15 tours/min).
- A T = 18 minutes : couler le béton à plat dans le ou les moules prévus à cet effet.

### Formulation (2) de béton autoplaçant :

La formulation (2) de béton autoplaçant utilisée pour réaliser les essais est décrite dans le tableau (2) suivant :

**Tableau (2) : formulation (2) de béton**

| Composant | Proportion (% en poids par rapport au poids de la composition) |
|---|---|
| Ciment Portland gris Lafarge Val d'Azergues | 16,5 |
| Filler calcaire BETOCARB HP | 8,5 |
| Sable 0/4 (taux d'humidité 2,2 %) | 35,8 |
| Gravier 5/10 (taux d'humidité 0,26 %) | 29,2 |
| Eau de gâchée | 8,1 |
| Adjuvant Optima 203 | 1,9 |

Le rapport eau/ciment est de 0,49. Il s'agit d'un béton ayant une résistance à la compression à 28 jours supérieure à 25 MPa.

Le béton autoplaçant selon la formulation (2) est réalisé au moyen d'un malaxeur de type SIPE. L'ensemble de l'opération est réalisé à 20°C. La méthode de préparation comprend les étapes suivantes :
- A T = 0 seconde : mettre les graviers et sables dans le bol de malaxeur et malaxer durant 20 secondes ;
- A T = 20 secondes : ajouter le ciment et le filler et malaxer pendant 15 secondes (140 tours/min) ; et
- A T = 35 secondes : ajouter de l'eau et l'adjuvant et malaxer pendant 180 secondes (140 tours/min) (T0 pour la méthode de mesure du temps de gâchée/prise).

### Formulation (3) de béton moussé :

La formulation (3) de béton moussé utilisée pour réaliser les essais est décrite dans le tableau (3) suivant :

**Tableau (3) : formulation (3) du béton moussé**

| Composant | Proportion (% en poids par rapport au poids de la composition) |
|---|---|
| Ciment Portland Lafarge Le Teil | 67,25 |
| Calcaire précipité SOCAL31 | 3,05 |
| EPB 530-027 | 0,15 |
| Mapeair LA/L | 0,23 |
| Eau totale | 29,32 |

Un coulis contenant du ciment, du Socal 31, un adjuvant EPB 530-017 et de l'eau est réalisé à l'aide d'un malaxeur Perrier pour mortier et ciment normalisés selon la norme EN-196-1 datant d'avril 2006. Le rapport eau/ciment est de 0,30. La méthode de préparation du coulis comprend les étapes suivantes :
- A T = 0 seconde : mettre le ciment et le Socal 31 le bol de malaxeur et malaxer durant 1 minute ;
- A T = 1 minutes : ajouter l'eau contenant l'EPB 530-027 lentement en 2 minutes (140 tours/min) ; et
- A T = 4 minutes : malaxer pendant 180 secondes (280 tours/min)

Ce coulis est ensuite mélangé manuellement à une mousse aqueuse réalisée à partir d'une solution de Mapeair LA/L à teneur de 25 g/L. La mousse aqueuse est réalisée à l'aide d'un mousseur dans laquelle la solution est mélangée à de l'air pour obtenir une mousse aqueuse de densité 0.045.

La masse volumique fraiche du béton moussé est de 393 kg/m3 ce qui correspond à une masse volumique sèche de 350 kg/m3. La résistance à la compression à 28 jours supérieure à 0,8 MPa.

### Procédé de coffrage avec un module photovoltaïque placé à l'horizontale et un béton de formulation (1) (ne faisant pas partie de l'invention):

Des plaques ont été réalisées par coffrage du béton frais selon la formulation (1) dans des moules en bois bakélisé sans agent de décoffrage. Au contact des moules ont été placés distinctement à l'horizontal différents types de modules photovoltaïques tels que décrits dans le tableau (4). Sur la face arrière de chaque module photovoltaïque, ont été appliqués au pinceau différents types de polymère tels que décrits dans le tableau (4).

L'épaisseur de polymère appliquée est d'environ 1 mm.

Dans certains cas, la face arrière du module photovoltaïque a été sablée au préalable durant quelques dizaines de secondes en utilisant du sable SIBELCO BE01.

Puis le béton frais de formulation (1) a été coulé au sein du moule, 15 minutes après l'application du polymère.

Chaque plaque de béton selon la formulation (1) a été démoulée 18 heures après le gâchage du ciment. Après démoulage selon l'invention, le module photovoltaïque adhérait bien avec le béton durci et était fonctionnel, délivrant une tension mesurable, tel que décrit dans le tableau (4) sous un éclairage de 100000 Lux.

L'adhérence entre le module photovoltaïque et le polymère était plus importante si la face arrière du module avait été sablée au préalable.

Par comparaison, les modules photovoltaïques placés au contact du moule et non recouvertes de polymère (procédé de comparaison) n'avaient pas adhéré avec le béton durci après démoulage.

**Tableau (4)**

| Procédés testés | Moules horizontaux | Type de module photovoltaïque placée au contact du moule | Sablage de la face arrière du module photovoltaïque | Polymère appliqué | Tension mesurée | Adhérence entre béton et module photovoltaïque |
|---|---|---|---|---|---|---|
| Essai n°1 | Bois bakélisé | Polymères organiques (OPV) (200x90x0,1 mm) | Oui | Indilatex, INDIL | 160 mV | Très Forte |
| Essai n°2 | | silicium polycristallin Solarmodul 4V/250mA (82x12 0x3mm) | Oui | BASF, Acronal S790 | 4,3 V | Très forte |
| Essai n°3 | | | Oui | Chryso, Resipoly Chrysor | 4,3 V | Très forte |
| Essai n°4 | | silicium polycristallin Solarmodul 6V/450mA (200x2 00x3mm) | Oui | BASF, Acronal S790 | 6,9 V | Très forte |
| Essai n°5 | | | Oui | Chryso, Resipoly Chrysor | 6,9 V | Très forte |
| Essai n°6 | | Souple et semi-transparent, silicium polycristallin Solarmodul 6V/400mA (200x1 80x2mm) | Non | BASF, Acronal S790 | 7,3 V | Faible |
| Essai n°7 | | | oui | | 7,3 V | Très forte |
| Essai n°8 | | Flexible, PVL-68 en silicium amorphe 12V/4, 1A (2849x3 94x4mm) | oui | Chryso, Resipoly Chrysor | 11,9 V | Très forte |
| Essai de comparaison | | Polymères organiques (OPV) 200x90x0,1 mm) | Non | Aucun | / | Aucune adhésion |
| Essai de comparaison | | silicium polycristallin Solarmodul 4V/250mA (82x12 0x3mm) | Oui | Aucun | / | Aucune adhésion |

### Procédé de coffrage avec un module photovoltaïque placé à la verticale avec béton de formulation (2) :

Des plaques ont été réalisés par moulage du béton selon la formulation (2) dans des moules verticaux en acier sans agent de décoffrage. Au contact des moules en acier, ont été placés distinctement différents types de modules photovoltaïques tels que décrits dans le tableau (5). Sur la face arrière de chaque module, a été appliqué au pinceau différents types de polymères tels que décrits dans le tableau (5).

L'épaisseur de polymère appliquée est d'environ 1 mm.

Dans certains cas, la face arrière du module photovoltaïque a été sablée au préalable durant quelques dizaines de secondes en utilisant du sable SIBELCO BE01. Puis le béton frais de formulation (2) a été coulé au sein du moule, 15 minutes après l'application du polymère.

Chaque plaque de béton selon la formulation (2) a été démoulée 20 heures après le le gâchage du ciment. Après démoulage, le module photovoltaïque adhérait bien avec le béton durci et était fonctionnel, délivrant une tension mesurable, tel que décrit dans le tableau (5) sous un éclairage de 100000 Lux. L'adhérence entre le module photovoltaïque et le polymère était plus importante si la face arrière de la cellule avait été sablée au préalable.

Par comparaison, les modules photovoltaïques placés au contact du moule et non recouvertes de polymère (procédé de comparaison) n'avaient pas adhérés avec le béton durci après démoulage.

**Tableau (5)**

| Procédés testés | Moules horizontaux | Type de module photovoltaïque placé au contact du moule | Sablage de la face arrière du module photovoltaïque | Polymère appliqué | Tension mesurée | Adhérence entre béton et module photovoltaïque |
|---|---|---|---|---|---|---|
| Essai n°1 selon l'invention | Acier | Silicium polycristallin Solarmodul 4V/250mA (82x 120x3mm) | Oui | BASF, Acronal S790 | 4,3 V | Très forte |
| Essai n°2 selon l'invention | | | Oui | Chryso, Resipoly Chrysor | 4,3 V | Très forte |
| Essai de comparaison | | | Non | Aucun | / | Aucune adhésion |

### Procédé de coffrage avec un module photovoltaïque placé à la verticale avec un béton de formulation (3) :

Une plaque a été réalisée par moulage du béton selon la formulation (3) dans un moule cubique en polystyrène et sans agent de décoffrage. Au contact des parois du moule en polystyrène, ont été placés des modules photovoltaïques tels que décrits dans le tableau (6).

Sur la face arrière de chaque module, a été appliqué au pinceau un polymère tel que décrit dans le tableau (6).

L'épaisseur de polymère appliquée est d'environ 1 mm.

Puis le béton frais de formulation (3) a été coulé au sein du moule, 15 minutes après l'application du polymère.

Le béton selon la formulation (3) a été démoulé 20 heures après le gâchage du ciment. Après démoulage, les modules photovoltaïques adhéraient bien avec le béton durci et étaient fonctionnels, délivrant une tension mesurable, tel que décrit dans le tableau (6) sous un éclairage de 100000 Lux.

**Tableau (6)**

| Procédé testé | Moule | Type de module photovoltaïque placée au contact du moule | Polymère appliqué | Tension mesurée | Adhérence entre béton et module photovoltaïque |
|---|---|---|---|---|---|
| Essai selon l'invention | Polystyrène | silicium polycristallin Solarmodul 4V/250mA (82x120x 3mm) | BASF, Acronal S790 | 4,3 V | Très forte |

## Revendications

1. Procédé de fabrication d'un élément préfabriqué (1) destiné à la construction et à la production d'électricité comprenant les étapes suivantes :
- disposer d'au moins un module photovoltaïque (2), ledit au moins un module photovoltaïque (2) présentant une face avant (2a) destinée à être orientée vers une source lumineuse et une face arrière (2b) opposée à la face avant (2a), ledit module photovoltaïque étant recouvert d'un polymère transparent,
- disposer d'un moule de coffrage (4),
- introduire l'au moins un module photovoltaïque (2) dans le moule de coffrage (4), pour cela :
- positionner l'au moins un module photovoltaïque (2) contre une des parois latérales (4a, 4b, 4c, 4d) du moule de coffrage (4), la face avant (2a) de l'au moins un module photovoltaïque (2) étant disposée en regard de ladite paroi (4a, 4b, 4c, 4d, 4e), l'au moins un module photovoltaïque (2) étant positionné à la verticale, et/ou
- remplacer une des parois latérale (4a, 4b, 4c, 4d) du moule de coffrage (4) par tout ou partie de l'au moins un module photovoltaïque (2), la face avant (2a) de l'au moins un module photovoltaïque (2) étant disposée en regard d'une zone de l'espace (E) située à l'extérieur du moule (4), l'au moins un module photovoltaïque (2) étant positionné à la verticale,
- déposer un matériau adhésif structurel (3) ou un mélange de matériaux adhésifs structurels (3) sur tout ou partie du polymère transparent recouvrant la face arrière (2b) de l'au moins un module photovoltaïque (2) disposée en regard d'une zone de l'espace (I) située à l'intérieur du moule (4), le matériau adhésif structurel (3) comprenant au moins un polymère de la famille des époxydes, des polyuréthanes, des acryliques ou des styrène-acryliques,
- couler un béton frais (6) dans le moule de coffrage (4) de manière à recouvrir le matériau adhésif structurel (3).

2. Procédé selon la revendication 1, dans lequel le matériau adhésif structurel est du type colle époxyde, et le béton frais est coulé alors même que la colle époxyde est encore fluide.

3. Procédé selon la revendication 1, dans lequel le matériau adhésif structurel est du type colle acrylique, et le procédé comprend en outre une étape de séchage ou de réticulation de la colle acrylique avant l'étape consistant à couler du béton frais (6).

4. Procédé selon l'une quelconque des revendications 1 à 3, comprenant en outre une étape préalable de sablage de la face arrière (2b) de l'au moins un module photovoltaïque (2).

5. Procédé selon l'une quelconque des revendications 1 à 4, dans lequel le matériau adhésif structurel (3) est appliqué par pulvérisation, à l'aide d'un rouleau ou à l'aide d'un pinceau.

6. Procédé selon l'une quelconque des revendications précédentes, dans lequel le béton (6) a un rapport eau sur ciment d'au plus 1, de préférence de 0,20 à 0,27.

7. Procédé selon l'une quelconque des revendications précédentes, comprenant en outre une étape ultérieure de démoulage, de préférence 18 heures après l'étape de coulage du béton frais (6).

8. Procédé selon la revendication 7, comprenant en outre une étape ultérieure de traitement thermique après l'étape de démoulage.

9. Procédé selon l'une quelconque des revendications précédentes, dans lequel le béton (6) est un béton haute performance, un béton ultra-haute performance, un béton autoplaçant ou un béton moussé.

## Patentansprüche

1. Verfahren zur Herstellung eines vorgefertigten Elements (1), das für den Bau und für die Erzeugung von Strom bestimmt ist, die folgenden Schritte umfassend:
- Anordnen von mindestens einem Photovoltaikmodul (2), wobei das mindestens eine Photovoltaikmodul (2) eine Vorderseite (2a), die dazu bestimmt ist, zu einer Lichtquelle ausgerichtet zu werden, und eine Rückseite (2b), entgegengesetzt zur Vorderseite (2a), aufweist, wobei das Photovoltaikmodul von einem durchsichtigen Polymer bedeckt ist,
- Anordnen einer Schalungsform (4),
- Einsetzen des mindestens einen Photovoltaikmoduls (2) in die Schalungsform (4), dazu:
- Positionieren des mindestens einen Photovoltaikmoduls (2) an einer der Seitenwände (4a, 4b, 4c, 4d) der Schalungsform (4), wobei die Vorderseite (2a) des mindestens einen Photovoltaikmoduls (2) gegenüber der Wand (4a, 4b, 4c, 4d, 4e) angeordnet ist, wobei das mindestens eine Photovoltaikmodul (2) in der Vertikalen positioniert ist, und/oder
- Ersetzen einer der Seitenwände (4a, 4b, 4c, 4d) der Schalungsform (4) durch das gesamte, oder einen Teil des mindestens einen Photovoltaikmoduls (2), wobei die Vorderseite (2a) des mindestens einen Photovoltaikmoduls (2) gegenüber einer Zone des Freiraumes (E) angeordnet ist, der außerhalb der Form (4) gelegen ist, wobei das mindestens eine Photovoltaikmodul (2) in der Vertikalen positioniert ist,
- Abscheiden eines strukturellen Haftmaterials (3) oder eines Gemisches aus strukturellen Haftmaterialien (3) auf dem gesamten, oder einem Teil des durchsichtigen Polymers, das die Rückseite (2b) des mindestens einen Photovoltaikmoduls (2) abdeckt, das gegenüber einer Zone des Freiraumes (I) angeordnet ist, die im Inneren der Form (4) gelegen ist, wobei das strukturelle Haftmaterial (3) mindestens ein Polymer aus der Familie der Epoxide, der Polyurethane, der Acryle oder der Styrol-Acryle umfasst,
- Gießen von frischem Beton (6) in die Schalungsform (4), um das strukturelle Haftmaterial (3) abzudecken.

2. Verfahren nach Anspruch 1, wobei das strukturelle Haftmaterial vom Typ Epoxidkleber ist, und der frische Beton selbst dann gegossen wird, wenn der Epoxidkleber noch flüssig ist.

3. Verfahren nach Anspruch 1, wobei das strukturelle Haftmaterial vom Typ Acrylkleber ist, und das Verfahren weiter einen Trocknungsschritt oder Vernetzungsschritt des Acrylklebers vor dem Schritt umfasst, der darin besteht, frischen Beton (6) zu gießen.

4. Verfahren nach einem der Ansprüche 1 bis 3, weiter einen vorbereitenden Sandstrahlschritt der Rückseite (2b) des mindestens einen Photovoltaikmoduls (2) umfassend.

5. Verfahren nach einem der Ansprüche 1 bis 4, wobei das strukturelle Haftmaterial (3) durch Zerstäuben, mithilfe einer Rolle oder mithilfe eines Pinsels aufgetragen wird.

6. Verfahren nach einem der vorstehenden Ansprüche, wobei der Beton (6) ein Verhältnis von Wasser zu Zement von höchstens 1, vorzugsweise von 0,20 zu 0,27 aufweist.

7. Verfahren nach einem der vorstehenden Ansprüche, weiter einen späteren Schritt des Ausformens, vorzugsweise 18 Stunden nach dem Schritt des Gießens von frischem Beton (6) umfasst.

8. Verfahren nach Anspruch 7, weiter einen späteren Schritt einer Wärmebehandlung nach dem Ausformschritt umfassend.

9. Verfahren nach einem der vorstehenden Ansprüche, wobei der Beton (6) ein Hochleistungsbeton, ein Ultra-Hochleistungsbeton, ein selbstverdichtender Beton oder ein geschäumter Beton ist.

## Claims

1. Method for manufacturing a pre-fabricated element (1) for construction and electricity production including the following steps:
- providing at least one photovoltaic module (2), said at least one photovoltaic module (2) having a front face (2a) intended to be oriented towards a light source and a rear face (2b) opposite to the front face (2a), said photovoltaic module being covered with a transparent polymer,
- providing a formwork mould (4),
- introducing the at least one photovoltaic module (2) into the formwork mould (4), and for this purpose:
- positioning the at least one photovoltaic module (2) against one of the side walls (4a, 4b, 4c, 4d) of the formwork mould (4), the front face (2a) of the at least one photovoltaic module (2) being arranged so as to face said wall (4a, 4b, 4c, 4d, 4e), the at least one photovoltaic module (2) being positioned vertically, and/or
- replacing one of the side walls (4a, 4b, 4c, 4d) of the formwork mould (4) by all or part of the at least one photovoltaic module (2), the front face (2a) of the at least one photovoltaic module (2) being arranged so as to face an area of the space (E) located outside the mould (4), the at least one photovoltaic module (2) being positioned vertically,
- depositing an adhesive structural material (3) or a mixture of adhesive structural materials (3) on all or part of the transparent polymer covering the rear face (2b) of the at least one photovoltaic module (2) arranged so as to face an area of the space (I) located inside the mould (4), the adhesive structural material (3) including at least one polymer from the epoxide, polyurethane, acrylic, or styreneacrylic family,
- pouring fresh concrete (6) into the formwork mould (4) so as to cover the adhesive structural material (3).

2. Method according to claim 1, wherein the adhesive structural material is of the epoxide adhesive type, and the fresh concrete is poured while the epoxide adhesive is still fluid.

3. Method according to claim 1, wherein the adhesive structural material is of the acrylic adhesive type, and the method further includes a step of drying or cross-linking the acrylic adhesive before the step consisting in pouring the fresh concrete (6).

4. Method according to any of claims 1 to 3, further including a prior step of sandblasting the rear face (2b) of the at least one photovoltaic module (2).

5. Method according to any of claims 1 to 4, wherein the adhesive structural material (3) is applied by spray, by roller or by brush.

6. Method according to any of the preceding claims, wherein the concrete (6) has a water/cement ratio of at the most 1, preferably from 0.20 to 0.27.

7. Method according to any of the preceding claims, further including a later step of removing from the mould, preferably 18 hours after the step of pouring the fresh concrete (6).

8. Method according to claim 7, further including a later step of thermal treatment after the step of removing from the mould.

9. Method according to any of the preceding claims, wherein the concrete (6) is a high performance concrete, an ultra-high performance concrete, a self-compacting concrete or a foamed concrete.
